# EUROPEAN PATENT APPLICATION

(11) **EP 2 264 511 A1**
(43) Date of publication of application: **22.12.2010**
(21) Application number: 08873854.7
(22) Date of filing: 04.11.2008
(51) Int. Cl.: G02B 26/08, G02B 19/00, G03F 7/20, H01L 21/027

(54) **SPATIAL LIGHT MODULATING UNIT, ILLUMINATION OPTICAL SYSTEM, ALIGNER, AND DEVICE MANUFACTURING METHOD**

(30) Priority: 11.04.2008 JP 2008103128
(71) Applicant: Nikon Corporation, Tokyo 100-8331 (JP)
(72) Inventor: TANAKA, Hirohisa, Tokyo 100-8331 (JP)
(74) Representative: HOFFMANN EITLE
(86) International application number: PCT/JP2008/069999
(87) International publication number: WO 2009/125511

(57) **Abstract**

An illumination optical system for illuminating an illumination target surface on the basis of light from a light source is an illumination optical system provided with a distribution forming optical system which forms a predetermined light intensity distribution on an illumination pupil, based on a flux of light having traveled via a spatial light modulator having a plurality of optical elements arrayed two-dimensionally and controlled individually, and the illumination optical system adopts the following configuration to prevent a problem that it becomes difficult to form a desired pupil intensity distribution because of arrival of regularly reflected light from portions of the spatial light modulator other than the plurality of optical elements, at the illumination pupil. Namely, an entrance-side optical system for guiding light to the plurality of optical elements and an exit-side optical system for guiding the light having traveled via the plurality of optical elements are configured by use of a first deflecting member and a second deflecting member, respectively, so that the regularly reflected light travels toward the outside of a reflecting surface of the second deflecting member.

## Description

### TECHNICAL FIELD

The present invention relates to a spatial light modulating unit, an illumination optical system, an exposure apparatus, and a device manufacturing method. More particularly, the present invention relates to an illumination optical system suitably applicable to an exposure apparatus for manufacturing such devices as semiconductor devices, imaging devices, liquid crystal display devices, and thin film magnetic heads by lithography.

### BACKGROUND ART

In a typical exposure apparatus of this type, a light beam emitted from a light source travels through a fly's eye lens as an optical integrator to form a secondary light source (a predetermined light intensity distribution on an illumination pupil in general) as a substantial surface illuminant consisting of a large number of light sources. The light intensity distribution on the illumination pupil will be referred to hereinafter as a "pupil intensity distribution." The illumination pupil is defined as a position such that an illumination target surface becomes a Fourier transform plane of the illumination pupil by action of an optical system between the illumination pupil and the illumination target surface (a mask or a wafer in the case of the exposure apparatus).

Beams from the secondary light source are condensed by a condenser lens to superposedly illuminate the mask on which a predetermined pattern is formed. Light passing through the mask travels through a projection optical system to be focused on the wafer, whereby the mask pattern is projected (or transferred) onto the wafer to effect exposure thereof. Since the pattern formed on the mask is a highly integrated one, an even illuminance distribution must be obtained on the wafer in order to accurately transfer this microscopic pattern onto the wafer.

There is a hitherto proposed illumination optical system capable of continuously changing the pupil intensity distribution (and, in turn, an illumination condition) without use of a zoom optical system (cf. Patent Document 1). In the illumination optical system disclosed in Patent Document 1, using a movable multi-mirror composed of a large number of microscopic mirror elements which are arranged in an array form and an inclination angle and inclination direction of each of which are individually driven and controlled, an incident beam is divided in microscopic units by respective reflecting surfaces to be deflected thereby, so as to convert a cross section of the incident beam into a desired shape or desired size and, in turn, so as to realize a desired pupil intensity distribution.

Patent Document 1: Japanese Patent Application Laid-open No, 2002-353105

### DISCLOSURE OF THE INVENTION

### Problem to be Solved by the Invention

Since the illumination optical system described in Patent Document 1 uses the spatial light modulator having the large number of microscopic mirror elements whose postures are individually controlled, degrees of freedom are high about change in shape and size of the pupil intensity distribution. However, not only regularly reflected light from the minor elements but also regularly reflected light, for example, from a surface of a base supporting the mirror elements can reach the illumination pupil. In this case, it becomes difficult to form a desired pupil intensity distribution because of influence of the regularly reflected light (generally, unwanted light) from the portions other than the mirror elements.

The present invention has been accomplished in view of the above problem and it is an object of the invention to provide an illumination optical system capable of achieving a desired pupil intensity distribution, for example, while suppressing the influence of the unwanted light from the portions other than the mirror elements of the spatial light modulator. It is another object of the present invention to provide an exposure apparatus capable of performing excellent exposure under an appropriate illumination condition, using the illumination optical system achieving the desired pupil intensity distribution while suppressing the influence of unwanted light.

### Means for Solving the Problem

In order to solve the above problem, a first aspect of the present invention provides a spatial light modulating unit comprising:
a spatial light modulator having a plurality of optical elements arrayed two-dimensionally and controlled individually; and
an exit-side optical system which guides light having traveled via the plurality of optical elements of the spatial light modulator,
wherein the exit-side optical system is configured so that zero-order light having traveled via a surface portion other than the plurality of optical elements and approximately parallel to an array plane where the plurality of optical elements are arrayed, does not pass through an entrance pupil of the exit-side optical system.

A second aspect of the present invention provides an illumination optical system which illuminates an illumination target surface on the basis of light from a light source, the illumination optical system comprising:
the spatial light modulating unit of the first aspect; and
a distribution forming optical system which forms a predetermined light intensity distribution on an illumination pupil conjugate with the entrance pupil, based on a flux of light having traveled via the spatial light modulator.

A third aspect of the present invention provides an exposure apparatus comprising the illumination optical system of the second aspect for illuminating a predetermined pattern, wherein the predetermined pattern is transferred onto a photosensitive substrate to effect exposure thereof.

A fourth aspect of the present invention provides a device manufacturing method comprising:
an exposure step of transferring the predetermined pattern onto the photosensitive substrate to effect exposure thereof, using the exposure apparatus of the third aspect,
a development step of developing the photosensitive substrate on which the predetermined pattern is transferred, to form a mask layer of a shape corresponding to the predetermined pattern on a surface of the photosensitive substrate; and
a processing step of processing the surface of the photosensitive substrate through the mask layer.

A fifth aspect of the present invention provides a spatial light modulator which modulates light incident thereto from a first optical system and guides the light to a second optical system,
the spatial light modulator comprising a plurality of optical elements arrayed two-dimensionally and controlled individually,
wherein optical surfaces of the plurality of optical elements in a standard state in which a parallel beam incident along an optical axis of the first optical system to the plurality of optical elements is guided via the plurality of optical elements and along an optical axis of the second optical system, are inclined around a predetermined axis relative to an array plane where the plurality of optical elements are arrayed.

### Effects of the Invention

In the illumination optical system of the present invention, for example, the optical surfaces of the plurality of optical elements in the standard state in which the parallel beam incident along the optical axis of the entrance-side optical system to the plurality of optical elements (e.g.*,* mirror elements) of the spatial light modulator is guided via the plurality of optical elements and along the optical axis of the exit-side optical system, are inclined around the predetermined axis relative to the array plane where the plurality of optical elements are arrayed, As a result, the zero-order light having traveled via the surface portion other than the plurality of optical elements and approximately parallel to the array plane where the plurality of optical elements are arrayed (e.g., unwanted light like regularly reflected light from the portions other than the mirror elements) does not pass through the entrance pupil of the exit-side optical system and therefore does not reach the illumination pupil of the illumination optical system.

In this manner, the illumination optical system of the present invention is able to achieve a desired pupil intensity distribution, for example, while suppressing the influence of the unwanted light from the portions other than the mirror elements of the spatial light modulator. The exposure apparatus of the present invention is able to perform excellent exposure under an appropriate illumination condition achieved according to a pattern characteristic of the mask, using the illumination optical system achieving the desired pupil intensity distribution while suppressing the influence of unwanted light, and, in turn, to manufacture excellent devices.

### Brief Description of the Drawings

Fig. 1 is a drawing schematically showing a configuration of an exposure apparatus according to an embodiment of the present invention.
Fig. 2 is a drawing schematically showing a basic configuration and action of a spatial light modulator according to the embodiment.
Fig. 3 is a partial perspective view of the spatial light modulator shown in Fig. 2.
Fig. 4 is a drawing schematically showing a comparative example for explaining the disadvantage of the conventional technology and the subject of the present invention,
Fig. 5 is a drawing schematically showing a configuration and action of a spatial light modulator according to a first example of the embodiment.
Fig. 6 is a drawing schematically showing a numerical example according to the first example.
Fig. 7 is a drawing schematically showing another numerical example according to the first example.
Fig. 8 is a drawing schematically showing a configuration and action of a spatial light modulator according to a second example of the embodiment.
Fig, 9 is a drawing schematically showing a numerical example according to the second example,
Fig. 10 is a drawing schematically showing another numerical example according to the second example.
Fig. 11 is a flowchart showing manufacturing steps of semiconductor devices.
Fig. 12 is a flowchart showing manufacturing steps of a liquid crystal device such as a liquid crystal display device.

### List of Reference Symbols

- 1: light source
- 2: beam sending unit
- 3: spatial light modulator
- 3a: main body of spatial light modulator
- 3b: drive unit
- 4: zoom optical system
- 5: fly's eye lens
- 6: condenser optical system
- 7: illumination field stop (mask blind)
- 8: field stop imaging optical system
- IL: illumination optical system
- CR: control unit
- M: mask
- PL: projection optical system
- W: wafer

### BEST MODES FOR CARRYING OUT THE INVENTION

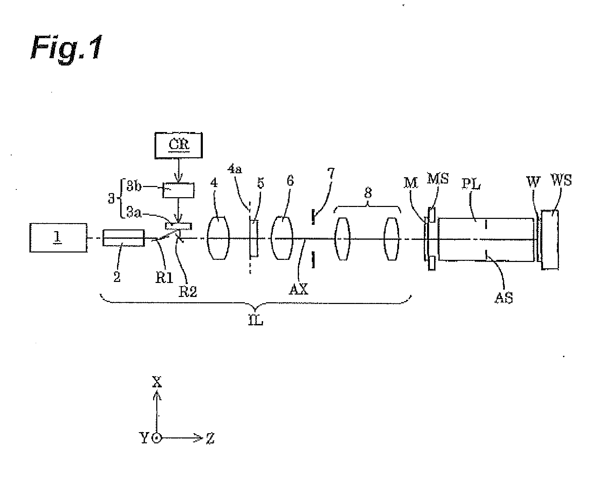

Embodiment of the present invention will be described on the basis of the accompanying drawings. Fig. 1 is a drawing schematically showing a configuration of an exposure apparatus according to an embodiment of the present invention. In Fig. 1, the Z-axis is set along a direction of a normal to an exposed surface of a wafer W being a photosensitive substrate, the X-axis is set along a direction parallel to the plane of Fig. 1 in the exposed surface of the wafer W, and the Y-axis is set along a direction perpendicular to the plane of Fig. 1 in the exposed surface of the wafer W.

Referring to Fig. 1, the exposure apparatus of the present embodiment has an illumination optical system IL including a spatial light modulator 3, a mask stage MS supporting a mask M, a projection optical system PL, and a wafer stage WS supporting the wafer W, along the optical axis AX of the apparatus. The exposure apparatus of the present embodiment is configured to illuminate the mask M with light from a light source 1, which supplies illumination light (exposure light), through the illumination optical system IL. Light transmitted by the mask M travels through the projection optical system PL to form an image of a pattern of the mask M on the wafer W.

The illumination optical system IL for illuminating a pattern surface (illumination target surface) of the mask M on the basis of the light from the light source 1 implements modified illumination such as multi-polar illumination (dipolar illumination, quadrupolar illumination, or the like) or annular illumination by action of the spatial light modulator 3. The illumination optical system IL has, in order from the light source 1 side along the optical axis AX, a beam sending unit 2, the spatial light modulator 3, a zoom optical system 4, a fly's eye lens 5, a condenser optical system 6, an illumination field stop (mask blind) 7, and a field stop imaging optical system 8.

The spatial light modulator 3 forms a desired light intensity distribution (pupil intensity distribution) in its far field region (Fraunhofer diffraction region), based on the light from the light source 1 through the beam sending unit 2, The configuration and action of the spatial light modulator 3 will be described later. The beam sending unit 2 has functions to guide an incident beam from the light source 1 to the spatial light modulator 3 while converting the incident beam into a beam having a cross section of an appropriate size and shape, and to actively correct variation in position and variation in angle of the beam incident to the spatial light modulator 3. The zoom optical system 4 condenses the light from the spatial light modulator 3 and guides the condensed light to the fly's eye lens 5.

The fly's eye lens 5 is an optical integrator of a wavefront division type consisting of a large number of lens elements arrayed densely, for example. The fly's eye lens 5 divides the wavefront of the incident beam to form a secondary light source (substantial surface illuminant) consisting of light source images as many as the lens elements, on its rear focal plane. An entrance plane of the fly's eye lens 5 is arranged at or near the rear focus position of the zoom optical system 4. The fly's eye lens 5 to be used herein can be, for example, a cylindrical micro fly's eye lens. The configuration and action of the cylindrical micro fly's eye lens are disclosed for example, in U.S. Pat. No. 6,913,373. It is also possible to use, for example, the micro fly's eye lens disclosed in U.S. Pat. No, 6,741,394, as the fly's eye lens. The teachings of U.S, Pat. Nos. 6,913,373 and 6,741,394 are incorporated herein by reference.

In the present embodiment, the mask M placed on the illumination target surface of the illumination optical system IL is illuminated by Köhler illumination using the secondary light source formed by the fly's eye lens 5, as a light source. For this, the position where the secondary light source is formed is optically conjugate with a position of an aperture stop AS of the projection optical system PL and a plane where the secondary light source is formed can be called an illumination pupil plane of the illumination optical system IL. Typically, the illumination target surface (the plane where the mask M is placed, or the plane where the wafer W is placed if the illumination optical system is considered to include the projection optical system PL) becomes an optical Fourier transform plane with respect to the illumination pupil plane.

The pupil intensity distribution is a light intensity distribution (luminance distribution) on the illumination pupil plane of the illumination optical system IL or on a plane optically conjugate with the illumination pupil plane. When the number of divisions of the wavefront by the fly's eye lens 5 is relatively large, an overall light intensity distribution formed on the entrance plane of the fly's eye lens 5 demonstrates a high correlation with an overall light intensity distribution (pupil intensity distribution) of the entire secondary light source. For this reason, the light intensity distributions on the entrance plane of the fly's eye lens 5 and on a plane optically conjugate with the entrance plane can also be called pupil intensity distributions.

The condenser optical system 6 condenses the light emitted from the fly's eye lens 5 to illuminate the illumination field stop 7 in a superimposed manner. Light passing through the illumination field stop 7 travels through the field stop imaging optical system 8 to form an illumination region being an image of an aperture of the illumination field stop 7, in at least a part of the pattern forming region on the mask M. Fig. 1 is depicted without installation of path bending mirrors for bending the optical axis (optical path eventually), but it should be noted that it is optional to arrange an appropriate number of path bending mirrors in the illumination optical path as needed.

The mask M is mounted along the XY plane (e.g., a horizontal plane) on the mask stage MS and the wafer W is mounted along the XY plane on the wafer stage WS. The projection optical system PL forms an image of the pattern of the mask M on the exposed surface (projection surface) of the wafer W, based on light from the illumination region formed on the pattern surface of the mask M by the illumination optical system IL. In this manner, the pattern of the mask M is successively transferred onto each of exposure regions on the wafer W by carrying out full-shot exposure or scan exposure while two-dimensionally driving and controlling the wafer stage WS in the plane (XY plane) perpendicular to the optical axis AX of the projection optical system PL and, therefore, while two-dimensionally driving and controlling the wafer W.

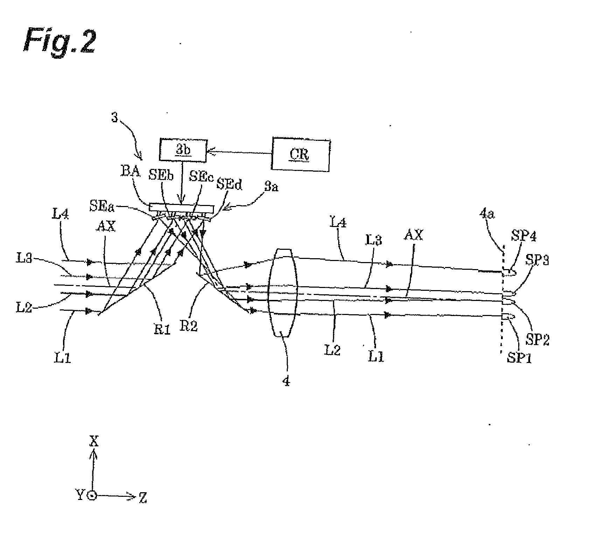

Fig. 2 is a drawing for explaining the basic configuration and action of the spatial light modulator according to the present embodiment. With reference to Fig. 2, the spatial light modulator 3 of the present embodiment is a spatial light modulator of a reflection type having a plurality of mirror elements, and is provided with a main body 3a and a drive unit 3b. The main body 3a has a plurality of microscopic mirror elements SE arrayed two-dimensionally along the YZ plane, and a basis (base) BA supporting the plurality of mirror elements SE. The drive unit 3b individually controls and drives postures of the mirror elements SE in accordance with a command from a control unit CR.

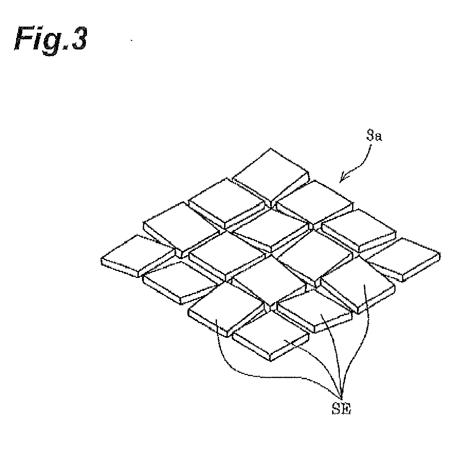

The spatial light modulator 3 imparts spatial modulations according to positions of incidence of incident rays, to the rays incident to the plurality of mirror elements SE via a first plane reflector (reflecting surface of R1) and emits the spatially modulated rays. The rays emitted from the spatial light modulator 3 travel via a reflecting surface of a second plane reflector R2 to enter the zoom optical system 4. The main body 3a of the spatial light modulator 3 is provided with a plurality of microscopic mirror elements (optical elements) SE arrayed two-dimensionally, as shown in Fig. 3. For simplicity of description and illustration, Figs. 2 and 3 show a configuration example in which the spatial light modulator 3 is provided with 4×4=16 mirror elements SE, but in fact it is provided with many more mirror elements SE than 16 elements.

With reference to Fig. 2, among a group of rays incident along a direction parallel to the optical axis AX to the reflecting surface of the first plane reflector R1, a ray L1 is incident to a mirror element SEa out of the plurality of mirror elements SE, and a ray L2 is incident to a mirror element SEb different from the mirror element SEa. Similarly, a ray L3 is incident to a mirror element SEc different from the mirror elements SEa, SEb and a ray L4 is incident to a mirror element SEd different from the mirror elements SEa-SEc, The mirror elements SEa-SEd impart respective spatial modulations set according to their positions, to the rays L1-L4.

The spatial light modulator 3 is arranged at or near the front focus position of the zoom optical system 4 as a condensing optical system. Therefore, the rays reflected and given a predetermined angle distribution by the plurality of mirror elements SEa-SEd of the spatial light modulator 3 form predetermined light intensity distributions SP1-SP4 on the rear focal plane 4a of the zoom optical system 4. Namely, the zoom optical system 4 converts angles given to the output rays by the plurality of mirror elements SEa-SEd of the spatial light modulator 3, into positions on the plane 4a being its far field region (Fraunhofer diffraction region).

Referring to Fig. 1, the entrance plane of the fly's eye lens 5 is positioned at the position of the rear focal plane 4a of the zoom optical system 4. Therefore, the light intensity distribution (luminance distribution) of the secondary light source formed by the fly's eye lens 5 becomes a distribution according to the light intensity distributions SP1-SP4 formed by the spatial light modulator 3 and the zoom optical system 4. The spatial light modulator 3, as shown in Fig. 3, is a movable multi-mirror including the mirror elements SE which are a large number of microscopic reflecting elements arrayed regularly and two-dimensionally along one plane in a state in which their reflecting surfaces of a planar shape are respective top faces.

Each mirror element SE is movable and an inclination of its reflecting surface, i.e., an inclination angle and inclination direction of the reflecting surface, is independently controlled by action of the drive unit 3b (which is not shown in Fig. 3) which operates in accordance with a command from the control unit CR (not shown in Fig. 3). Each mirror element SE is continuously or discretely rotatable by a desired rotation angle around axes of rotation along two mutually orthogonal directions (Y-direction and Z-direction) which are two directions parallel to its reflecting surface. Namely, the inclination of the reflecting surface of each mirror element SE can be two-dimensionally controlled.

When the reflecting surface of each mirror element SE is discretely rotated, a preferred control method is to switch the rotation angle among a plurality of states (e.g., ..., -2.5°, -2.0°,...0°, +0.5°...+2.5°,...). Fig. 3 shows the mirror elements SE with the contour of a rectangular shape, but the contour of the mirror elements SE is not limited to the rectangular shape. However, in terms of light utilization efficiency, it is also possible to adopt a shape enabling an array with a small clearance between the mirror elements SE (shape enabling closest packing), Furthermore, in terms of light utilization efficiency, it is also possible to adopt a configuration wherein the clearance between two adjacent element mirrors SE is reduced to the minimum necessary.

The present embodiment uses as the spatial light modulator 3, a spatial light modulator which continuously (or discretely) varies each or orientations of the mirror elements SE arrayed two-dimensionally. The spatial light modulator of this type applicable herein can be selected, for example, from the spatial light modulators disclosed in Published Japanese Translation of PCT Application No. 10-503300 and European Patent Published Application No, 779530 corresponding thereto, Japanese Patent Application Laid-open No. 2004-78136 and U.S, Pat, No. 6,900,915 corresponding thereto, Published Japanese Translation of PCT Application No. 2006-524349 and U.S. Pat. No. 7,095,546 corresponding thereto, and Japanese Patent Application Laid-open No. 2006-113437. The teachings of European Patent Published Application No. 779530, U.S. Pat. No. 6,900,915, and U.S. Pat. No. 7,095,546 are incorporated herein by reference.

In the spatial light modulator 3, postures of the respective mirror elements SE each are varied and the mirror elements SE are set in respective predetermined orientations, by action of the drive unit 3b operating in accordance with a control signal from the control unit CR. Rays reflected at respective predetermined angles by the plurality of mirror elements SE of the spatial light modulator 3 travel through the zoom optical system 4 to form a light intensity distribution (pupil intensity distribution) of a multi-polar shape (dipolar shape, quadrupolar shape, or the like), annular shape, or the like on the illumination pupil at or near the rear focus position of the fly's eye lens 5. This pupil intensity distribution similarly (isotropically) varies by action of the zoom optical system 4.

Namely, the zoom optical system 4 and the fly's eye lens 5 constitute a distribution forming optical system which forms a predetermined light intensity distribution on the illumination pupil of the illumination optical system IL, based on a flux of light having traveled via the spatial light modulator 3. Furthermore, light intensity distributions corresponding to the pupil intensity distribution are also formed at other illumination pupil positions optically conjugate with the illumination pupil at or near the rear focus position of the fly's eye lens 5, i,e., at a pupil position of the field stop imaging optical system 8 and at a pupil position of the projection optical system PL (position of the aperture stop AS).

For the exposure apparatus to highly accurately and faithfully transfer the pattern of the mask M onto the wafer W, it is important, for example, to perform exposure under an appropriate illumination condition according to a pattern characteristic of the mask M. Since the illumination optical system IL of the present embodiment adopts the spatial light modulator 3 wherein the postures of the mirror elements SE each are individually varied, the pupil intensity distribution formed by action of the spatial light modulator 3 can be freely and quickly varied,

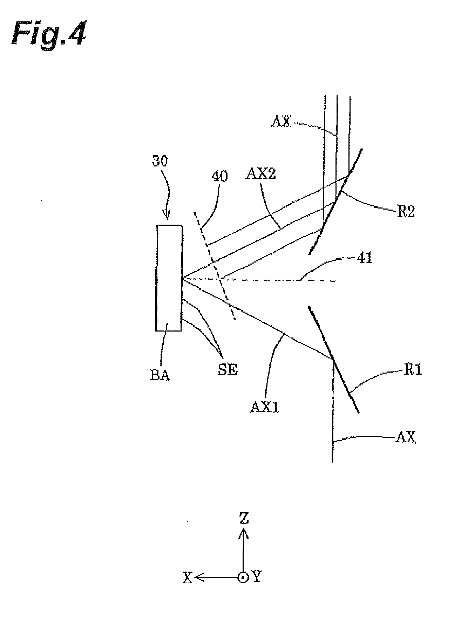

In the illumination optical system configured by ordinary design using the reflection type spatial light modulator having the plurality of mirror elements, however, not only the regularly reflected light from the minor elements but also the regularly reflected light from the surface of the base supporting the mirror elements, and others reaches the illumination pupil, as described previously. In this case, it becomes difficult to form a desired pupil intensity distribution because of influence of the regularly reflected light (unwanted light) from the portions other than the mirror elements. The below will describe the disadvantage of the conventional technology and the subject of the present invention with reference to a comparative example of Fig. 4 configured according to the ordinary design.

The spatial light modulator 30 according to the comparative example shown in Fig. 4 is configured in a configuration wherein in a standard state in which the reflecting surfaces of the mirror elements SE are set in parallel with the YZ plane, rays incident along the direction parallel to the optical axis AX to the reflecting surface of the first plane reflector R1 travel via the spatial light modulator 30 and thereafter are reflected toward the direction parallel to the optical axis AX by the reflecting surface of the second plane reflector R2. In other words, the reflecting surfaces of the mirror elements SE in the standard state in which the rays incident along the direction parallel to the optical axis AX to the reflecting surface of the first plane reflector R1 travel via the plurality of mirror elements SE to be reflected toward the direction parallel to the optical axis AX by the reflecting surface of the second plane reflector R2 (which will be preferred to hereinafter simply as the "standard state"), coincide with an array plane (YZ plane) on which the plurality of mirror elements SE are arrayed.

In the comparative example shown in Fig. 4, the surface of the base BA supporting the plurality of mirror elements SE is parallel to the array plane of the mirror elements SE and therefore parallel to the reflecting surfaces of the mirror elements SE in the standard state. Therefore, not only the regularly reflected light from the mirror elements SE but also the regularly reflected light from the surface of the base BA reaches the illumination pupil (corresponding to the rear focal plane of the fly's eye lens 5 in Fig. 1) via the reflecting surface of the second plane reflector R2 and the zoom optical system 4 (not shown in Fig. 4). In the case of the spatial light modulator 30 of a type in which a mirror frame is provided between the mirror elements SE, regularly reflected light from the top surface of the mirror frame also reaches the illumination pupil similarly. Namely, the regularly reflected light from the surface portions other than the plurality of mirror elements SE and approximately parallel to the array plane of the mirror elements SE becomes unwanted light to reach the illumination pupil, As a result, in the comparative example shown in Fig. 4, it is difficult to form a desired pupil intensity distribution because of influence of the unwanted light from the portions other than the mirror elements SE.

Furthermore, in the comparative example shown in Fig. 4, a plane optically conjugate with the illumination pupil on the rear focal plane of the fly's eye lens 5 is inclined relative to the array plane (YZ plane) of the mirror elements SE as indicated by a dashed line 40 in the drawing. An angle or the conjugate plane 40 (which is depicted at a position apart from the spatial light modulator 30 for clarity or the drawing) conjugate with the illumination pupil, with respect to the array plane of the mirror elements SE is equal to an angle between an exit optical axis AX2 from the spatial light modulator 30 to the second plane reflector R2 and a normal (line segment extending along the X-direction) 41 to the reflecting surfaces of the mirror elements SE in the standard state, and therefore equal to an angle between an entrance optical axis AX1 from the first plane reflector R1 to the spatial light modulator 30 and the normal 41. As a result, for example, even if the reflecting surfaces of mirror elements in the central region are made coincident with the conjugate plane 40 of the illumination pupil, the reflecting surfaces of peripheral mirror elements will have a positional deviation in the direction of the exit optical axis AX2 from the conjugate plane 40 and it will be thus difficult to form a desired pupil intensity distribution.

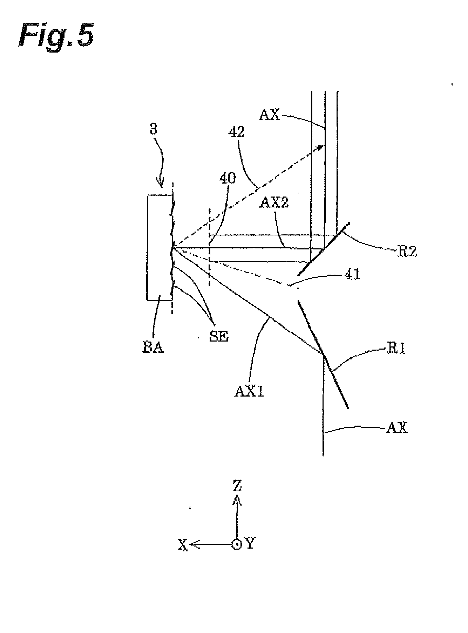

Fig. 5 is a drawing schematically showing the configuration and action of the spatial light modulator according to a first example of the present embodiment. In the spatial light modulator 3 of the first example, the surface of the base BA and the array plane of the mirror elements SE are set in parallel with the YZ plane as in the case of the comparative example of Fig. 4. In the first example, different from the comparative example of Fig. 4, the exit optical axis AX2 from the spatial light modulator 3 to the second plane reflector R2 is, however, set so as to extend along the X-direction. For this reason, the normal 41 to the reflecting surfaces of the mirror elements SE in a standard state is inclined relative to the X-axis by half of the angle between the exit optical axis AX2 and the entrance optical axis AX1 so that the angle between the normal 41 and the exit optical axis AX2 becomes equal to the angle between the normal 41 and the entrance optical axis AX1. In other words, the reflecting surfaces of the mirror elements SE in the standard state are inclined around the Y-axis by half of the angle between the exit optical axis AX2 and the entrance optical axis AX1 with respect to the array plane of the mirror elements SE.

As a result, when the spatial light modulator 3 of the first example is in the standard state in which the reflecting surfaces of the mirror elements SE are inclined with respect to the YZ plane, rays incident along the direction parallel to the entrance optical axis AX1 to the mirror elements SE to be reflected thereby travel along the direction parallel to the exit optical axis AX2 to impinge on the second plane reflector R2, and thereafter are reflected toward the optical axis AX by the reflecting surface thereof. On the other hand, rays incident to the surface portions (the surface of the base BA and others) other than the mirror elements SE and approximately parallel to the array plane of the mirror elements SE to be regularly reflected thereby are guided into a direction indicated by arrow 42 in the drawing (i.e., into a direction in symmetry with the entrance optical axis AX1 with respect to the exit optical axis AX2) and therefore they do not reach an effective region of the reflecting surface of the second plane reflector R2 and, consequently, do not reach the illumination pupil on the rear focal plane of the fly's eye lens 5. The surface portions other than the mirror elements SE and approximately parallel to the array plane of the mirror elements SE are located between the mirror elements SE.

In this manner the first example is able to achieve a desired pupil intensity distribution, while suppressing the influence of the unwanted light from the portions other than the mirror elements SE of the spatial light modulator 3. Since in the first example the exit optical axis AX2 extends along the X-direction so as to be perpendicular to the array plane of the mirror elements SE, the conjugate plane 40 of the illumination pupil becomes parallel to the array plane of the mirror elements SE, As a result, the reflecting surfaces of the mirror elements SE not only in the central region but throughout the entire region can be made approximately coincident with the conjugate plane 40 and therefore it becomes easier to form a desired pupil intensity distribution.

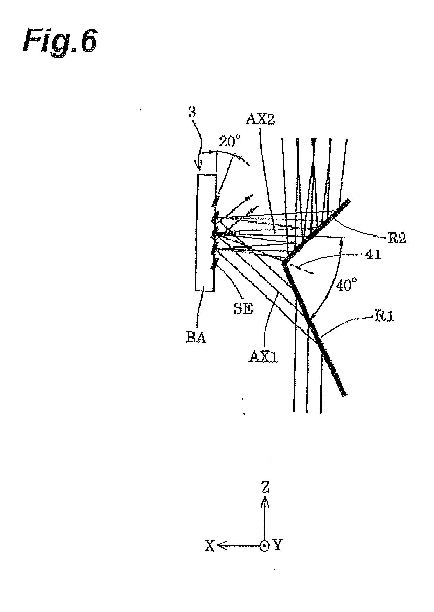

In a numerical example shown in Fig. 6, based on the configuration of the first example, the angle between the entrance optical axis AX1 and the exit optical axis AX2 is set at 40°, Namely, the angle between the normal 41 and the exit optical axis AX2 and the angle between the normal 41 and the entrance optical axis AX1 both are set at 20°, Therefore, the reflecting surfaces of the mirror elements SE in the standard state are inclined at 20° around the Y-axis relative to the array plane of the mirror elements SE.

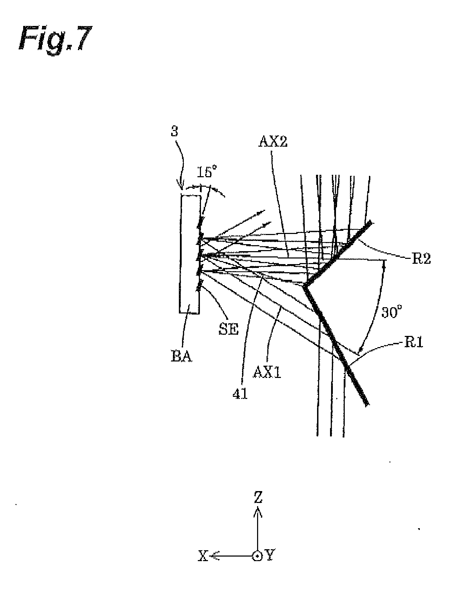

In another numerical example shown in Fig. 7, based on the configuration of the first example, the angle between the entrance optical axis AX1 and the exit optical axis AX2 is set at 30°. Namely, the angle between the normal 41 and the exit optical axis AX2 and the angle between the normal 41 and the entrance optical axis AX1 both are set at 15°. Therefore, the reflecting surfaces of the mirror elements SE in the standard state are inclined at 15° around the Y-axis relative to the array plane of the mirror elements SE.

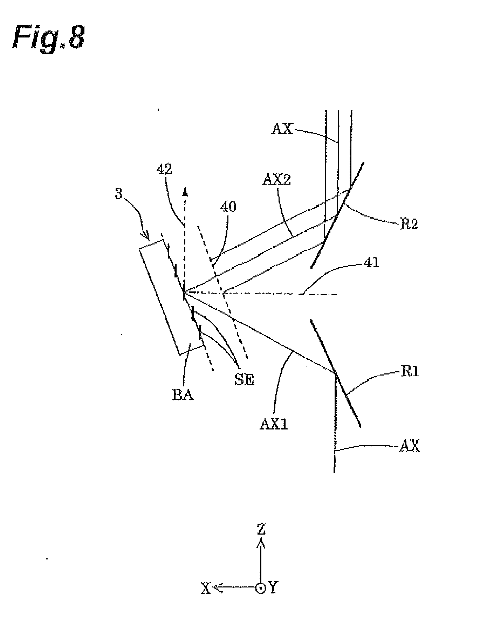

Fig. 8 is a drawing schematically showing the configuration and action of the spatial light modulator according to a second example of the present embodiment. In the spatial light modulator 3 of the second example, as in the comparative example of Fig. 4, the entrance optical axis AX1 from the first plane reflector R1 to the spatial light modulator 3 and the exit optical axis AX2 from the spatial light modulator 3 to the second plane reflector R2 are set in symmetry with respect to the X-axis so as to make the same angle to the X-axis. In the second example, different from the comparative example of Fig. 4, the surface of the base BA and the array plane of the mirror elements SE are, however, set with an inclination relative to the YZ plane. For this reason, the normal 41 to the reflecting surfaces of the mirror elements SE in the standard state extends along the X-direction so that the angle between the normal 41 and the exit optical axis AX2 becomes equal to the angle between the normal 41 and the entrance optical axis AX1. In other words, the reflecting surfaces of the mirror elements SE in the standard state are parallel to the YZ plane and inclined around the Y-axis by half of the angle between the exit optical axis AX2 and the entrance optical axis AX1 with respect to the array plane of the mirror elements SE.

As a result, when the spatial light modulator 3 of the second example is in the standard state in which the reflecting surfaces of the mirror elements SE are set in parallel with the YZ plane, rays incident along the direction parallel to the entrance optical axis AX1 to the mirror elements SE to be reflected thereby travel along the direction parallel to the exit optical axis AX2 to impinge on the second plane reflector R2 and thereafter they are reflected toward the optical axis AX by the reflecting surface thereof. On the other hand, rays incident to the surface portions (the surface of the base BA and others) other than the mirror elements SE and approximately parallel to the array plane of the mirror elements SE to be regularly reflected thereby are guided into a direction indicated by arrow 42 in the drawing (i.e., into the direction in symmetry with the entrance optical axis AX1 with respect to the exit optical axis AX2) and therefore they do not reach the effective region of the reflecting surface of the second plane reflector R2 and, consequently, do not reach the illumination pupil on the rear focal plane of the fly's eye lens 5.

In this manner, the second example is also able to achieve a desired pupil intensity distribution while suppressing the influence of the unwanted light from the portions other than the mirror elements SE of the spatial light modulator 3 as the first example is. In the second example, as in the first example, the exit optical axis AX2 extends along the direction perpendicular to the array plane of the mirror elements SE, and therefore the conjugate plane 40 of the illumination pupil becomes parallel to the array plane of the mirror elements SE. As a consequence, the reflecting surfaces of the mirror elements SE not only in the central region but throughout the entire region can be made approximately coincident with the conjugate plane 40 and therefore it becomes easier to form a desired pupil intensity distribution.

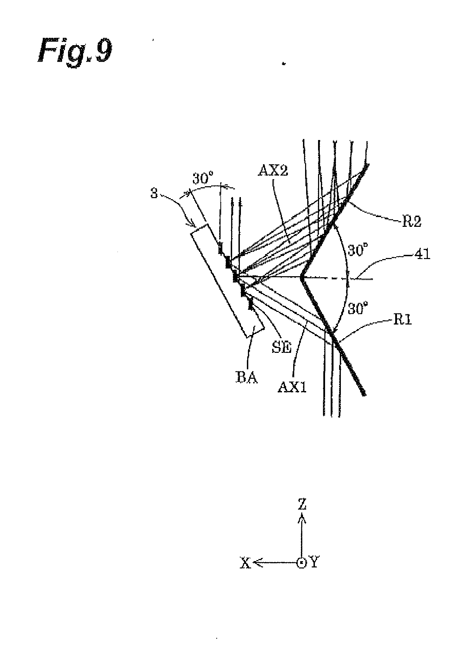

In a numerical example shown in Fig. 9, based on the configuration of the second example, the angle between the entrance optical axis AX1 and the exit optical axis AX2 is set at 60°. Namely, the angle between the normal 41 and the exit optical axis AX2 and the angle between the normal 41 and the entrance optical axis AX1 both are set at 30°. Therefore, the reflecting surfaces of the mirror elements SE in the standard state are inclined at 30° around the Y-axis relative to the array plane of the mirror elements SE.

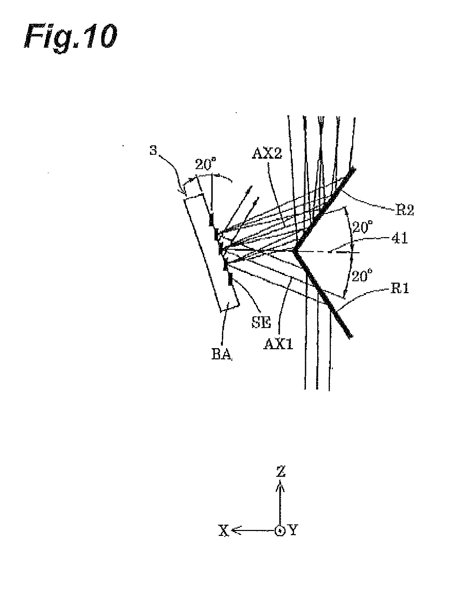

In another numerical example shown in Fig. 10, based on the configuration of the second example, the angle between the entrance optical axis AX1 and the exit optical axis AX2 is set at 40°. Namely, the angle between the normal 41 and the exit optical axis AX2 and the angle between the normal 41 and the entrance optical axis AX1 both are set at 20°. Therefore, the reflecting surfaces of the mirror elements SE in the standard state are inclined at 20° around the Y-axis relative to the array plane of the mirror elements SE.

The above description illustrated the two numerical examples based on the configuration of the first example and the two numerical examples based on the configuration of the second example, but, without having to be limited to them, it is also possible to contemplate a variety of forms as to numerical examples based on the configuration of the first example and numerical examples based on the configuration of the second example. The above description illustrated the first example and the second example as specific configuration examples of the spatial light modulator according to the present invention, but, without having to be limited to them, it is also possible to contemplate a variety of forms as to specific configurations of the spatial light modulator according to the present invention.

Incidentally, it can be considered in the foregoing embodiment that the second plane reflector R2 alone or, the cooperative combination of the second plane reflector R2 and the zoom optical system 4 constitutes an exit-side optical system for guiding the light having traveled via the plurality of mirror elements SE of the spatial light modulator 3 and that the exit-side optical system and the spatial light modulator 3 constitute a spatial light modulating unit. It can also be considered that the first plane reflector R1 alone or, the cooperative combination of the optical system in the beam sending unit 2 and the first plane reflector R1 constitutes an entrance-side optical system for guiding the light to the plurality of mirror elements SE of the spatial light modulator 3 and that the entrance-side optical system, the exit-side optical system, and the spatial light modulator 3 constitute a spatial light modulating unit.

In either case, the spatial light modulating unit in the foregoing embodiment is configured so that the zero-order light (regularly reflected light) having traveled via the surface portions other than the mirror elements SE of the spatial light modulator 3 and approximately parallel to the array plane of the mirror elements SE does not pass through the entrance pupil of the exit-side optical system optically conjugate with the illumination pupil of the illumination optical system IL and therefore does not reach the illumination pupil. In passing, when the exit-side optical system is considered to be composed of only a deflecting member such as a plane reflector or a prism, the exit-side optical system has no scientific entrance pupil and in this case, that the zero-order light does not pass through the entrance pupil of the exit-side optical system can mean that the zero-order light travels toward the outside of an entrance pupil defined by a subsequent optical system including the exit-side optical system or toward the outside of a conjugate image of the entrance pupil.

In the foregoing embodiment, in order to make widths of diffraction blurs on the illumination pupil by diffracted light from the reflecting surface of the mirror element SE, symmetric in a direction toward one side and in a direction toward the other side of the rectangular reflecting surface, it is preferable to adopt a configuration wherein an apparent contour of the reflecting surface of the mirror element SE becomes square when viewed along the exit optical axis AX2 from the illumination pupil side. For that, for example, in each of the examples of Fig. 5 and Fig. 8, the length in the Z-direction (precisely, in the direction in which the cross section of the reflecting surface of the mirror element SE is elongated in the XZ plane) of the rectangular reflecting surface of the mirror element SE needs to be set to a required length larger than the length in the Y-direction.

In the foregoing embodiment, the front optical axis AX of the entrance-side optical system extending from the first plane reflector R1 to the front side (light source side) and the rear optical axis AX of the exit-side optical system extending from the second plane reflector R2 to the rear side (mask side) extend along one straight line. When the front optical axis AX and the rear optical axis AX on both sides of the spatial light modulator 3 are set in coincidence or in parallel with each other to make the upstream and downstream optical paths of the spatial light modulator 3 coaxial (or parallel), as described above, the optical system can be used, for example, in common with the conventional illumination optical apparatus using the diffractive optical element for formation of the pupil intensity distribution.

In the foregoing embodiment, the first plane reflector R1 and the second plane reflector R2 are used as a first deflecting member for deflecting the light from the beam sending unit 2 to guide the light to the spatial light modulator 3 and as a second deflecting member for deflecting the light from the spatial light modulator 3 to guide the light to the zoom optical system 4, respectively. However, without having to be limited to this, it is also possible to use a prism or a plurality of prisms having a required cross-sectional shape as the first deflecting member and the second deflecting member.

The spatial light modulating unit in the foregoing embodiment is configured so that the zero-order light (regularly reflected light) having traveled via the surface portions other than the mirror elements SE of the spatial light modulator 3 and approximately parallel to the array plane of the mirror elements SE is not incident to the entrance-side optical system (beam sending unit 2). This can prevent an adverse effect caused when the zero-order light from the spatial light modulator 3 returns to the light source.

In the above description, the spatial light modulator in which the orientations (angles: inclinations) of the reflecting surfaces arrayed two-dimensionally can be individually controlled is used as the spatial light modulator having the plurality of optical elements arrayed two-dimensionally and controlled individually. However, without having to be limited to this, it is also possible, for example, to apply a spatial light modulator in which heights (positions) of the reflecting surfaces arrayed two-dimensionally can be individually controlled. Such a spatial light modulator applicable herein can be selected, for example, from those disclosed in Japanese Patent Application Laid-open No. 6-281869 and U.S. Pat. No. 5,312,513 corresponding thereto, and in Fig. 1d of Published Japanese Translation of PCT Application No. 2004-520618 and U.S. Pat. No. 6,885,493 corresponding thereto. These spatial light modulators are able to apply the same action as a diffracting surface, to incident light by forming a two-dimensional height distribution. The aforementioned spatial light modulator having the plurality of reflecting surfaces arrayed two-dimensionally may be modified, for example, according to the disclosure in Published Japanese Translation of PCT Application No. 2006-513442 and U.S. Pat. No. 6,891,655 corresponding thereto, or according to the disclosure in Published Japanese Translation of PCT Application No. 2005-524112 and U.S. Pat. Published Application No. 2005/0095749 corresponding thereto.

In the above description, the spatial light modulator applied is the reflection type spatial light modulator having the plurality of mirror elements, but, without having to be limited to this, it is also possible, for example, to apply the transmission type spatial light modulator disclosed in U.S. Pat. No. 5,229,872. The teachings of U.S. Pat. Nos. 5,312,513, 6,885,493, and 6,891,655, U.S. Pat. Published Application No. 2005/0095749, and U.S. Pat. No. 5,229,872 are incorporated herein by reference.

In the above-described embodiment, the optical system may be modified so that in the formation of the pupil intensity distribution using the spatial light modulator, the pupil intensity distribution is measured with a pupil luminance distribution measuring device and the spatial light modulator is controlled according to the result of the measurement. Such technology is disclosed, for example, in Japanese Patent Application Laid-open No. 2006-54328 and in Japanese Patent Application Laid-open No. 2003-22967 and U.S. Pat. Published Application No. 2003/0038225 corresponding thereto. The teachings of U.S. Pat. Published Application No. 2003/0038225 are incorporated herein by reference.

In the aforementioned embodiment, the mask can be replaced with a variable pattern forming device which forms a predetermined pattern on the basis of predetermined electronic data. Use of such a variable pattern forming device can minimize influence on synchronization accuracy even if the pattern surface is set vertical. The variable pattern forming device applicable herein can be, for example, a DMD (Digital Micromirror Device) including a plurality of reflective elements driven based on predetermined electronic data. The exposure apparatus with the DMD is disclosed, for example, in Japanese Patent Application Laid-open No. 2004-304135, International Publication WO2006/080285, and U.S. Pat. Published Application No. 2007/0296936 corresponding thereto. Besides the reflective spatial light modulators of the non-emission type like the DMD, it is also possible to apply a transmission type spatial light modulator or a self-emission type image display device. It is noted that the variable pattern forming device can also be used in cases where the pattern surface is set horizontal. The teachings of U.S. Pat. Published Application No. 2007/0296936 are incorporated herein by reference.

In the foregoing embodiment, the fly's eye lens 5 was used as an optical integrator, but an optical integrator of an internal reflection type (typically, a rod type integrator) may be used instead thereof. In this case, a condenser lens is arranged behind the zoom optical system 4 so that its front focus position coincides with the rear focus position of the zoom optical system 4, and the rod type integrator is arranged so that an entrance end thereof is positioned at or near the rear focus position of the condenser lens. At this time, an exit end of the rod type integrator is at the position of the illumination field stop 7. In the use of the rod type integrator, a position optically conjugate with the position of the aperture stop AS of the projection optical system PL, in the field stop imaging optical system 8 downstream the rod type integrator can be called an illumination pupil plane. Since a virtual image of the secondary light source on the illumination pupil plane is formed at the position of the entrance plane of the rod type integrator, this position and positions optically conjugate therewith can also be called illumination pupil planes. The zoom optical system 4 and the foregoing condenser lens can be regarded as a condensing optical system arranged in the optical path between the optical integrator and the spatial light modulator, and the zoom optical system 4, the foregoing condenser lens, and the rod type integrator can be regarded as a distribution forming optical system.

The exposure apparatus of the foregoing embodiment is manufactured by assembling various sub-systems containing their respective components as set forth in the scope of claims in the present application, so as to maintain predetermined mechanical accuracy, electrical accuracy, and optical accuracy. For ensuring these various accuracies, the following adjustments are carried out before and after the assembling: adjustment for achieving the optical accuracy for various optical systems; adjustment for achieving the mechanical accuracy for various mechanical systems; adjustment for achieving the electrical accuracy for various electrical systems. The assembling steps from the various sub-systems into the exposure apparatus include mechanical connections, wire connections of electric circuits, pipe connections of pneumatic circuits, etc. between the various sub-systems. It is needless to mention that there are assembling steps of the individual sub-systems, before the assembling steps from the various sub-systems into the exposure apparatus. After completion of the assembling steps from the various sub-systems into the exposure apparatus, overall adjustment is carried out to ensure various accuracies as the entire exposure apparatus. The manufacture of the exposure apparatus may be performed in a clean room in which the temperature, cleanliness, etc. are controlled.

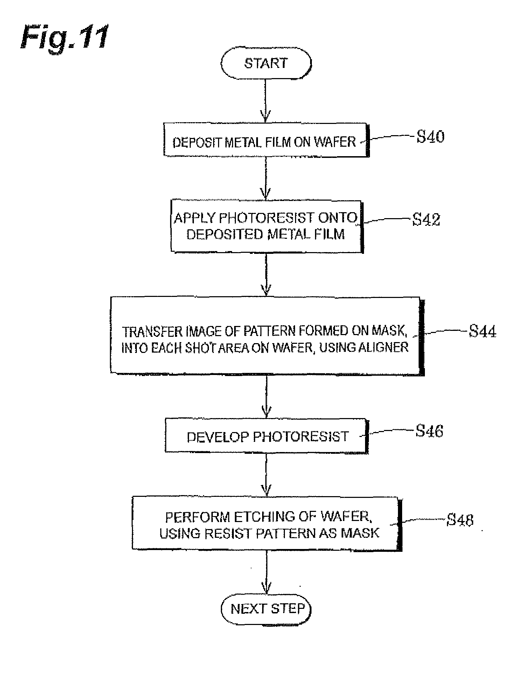

The following will describe a device manufacturing method using the exposure apparatus according to the above-described embodiment. Fig. 11 is a flowchart showing manufacturing steps of semiconductor devices. As shown in Fig. 11, the manufacturing steps of semiconductor devices include depositing a metal film on a wafer W to become a substrate of semiconductor devices (step S40) and applying a photoresist as a photosensitive material onto the deposited metal film (step S42). The subsequent steps include transferring a pattern formed on a mask (reticle) M, into each shot area on the wafer W, using the projection exposure apparatus of the above embodiment (step S44: exposure step), and developing the wafer W after completion of the transfer, i.e., developing the photoresist on which the pattern is transferred (step S46: development step). Thereafter, using the resist pattern made on the surface of the wafer W in step S46, as a mask, processing such as etching is carried out on the surface of the wafer W (step S48: processing step).

The resist pattern herein is a photoresist layer in which depressions and projections are formed in a shape corresponding to the pattern transferred by the projection exposure apparatus of the above embodiment and which the depressions penetrate throughout. Step S48 is to process the surface of the wafer W through this resist pattern. The processing carried out in step S48 includes, for example, at least either etching of the surface of the wafer W or deposition of a metal film or the like. In step S44, the projection exposure apparatus of the above embodiment performs the transfer of the pattern onto the wafer W coated with the photoresist, as a photosensitive substrate or plate P.

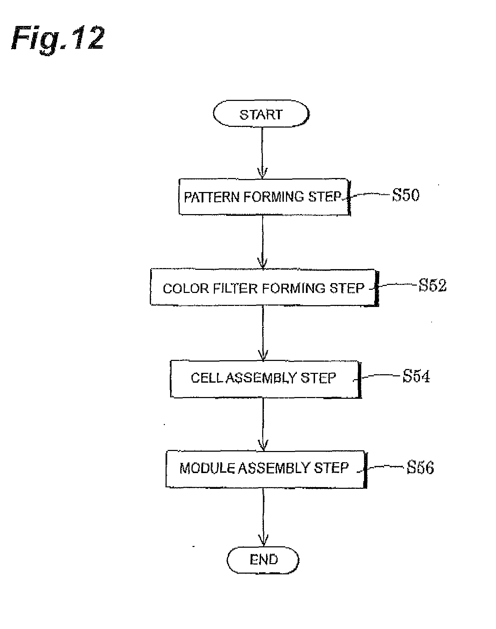

Fig. 12 is a flowchart showing manufacturing steps of a liquid crystal device such as a liquid crystal display device. As shown in Fig. 12, the manufacturing steps of the liquid crystal device include sequentially performing a pattern forming step (step S50), a color filter forming step (step S52), a cell assembly step (step S54), and a module assembly step (step S56).

The pattern forming step of step S50 is to form predetermined patterns such as a circuit pattern and an electrode pattern on a glass substrate coated with a photoresist, as a plate P, using the aforementioned projection exposure apparatus of the above embodiment. This pattern forming step includes an exposure step of transferring a pattern to a photoresist layer, using the projection exposure apparatus of the above embodiment, a development step of performing development of the plate P on which the pattern is transferred, i.e., development of the photoresist layer on the glass substrate, to form the photoresist layer in the shape corresponding to the pattern, and a processing step of processing the surface of the glass substrate through the developed photoresist layer.

The color filter forming step of step S52 is to form a color filter in which a large number of sets of three dots corresponding to R (Red), G (Green), and B (Blue) are arrayed in a matrix pattern, or in which a plurality of filter sets of three stripes of R, G, and B are arrayed in a horizontal scan direction.

The cell assembly step of step S54 is to assemble a liquid crystal panel (liquid crystal cell), using the glass substrate on which the predetermined pattern has been formed in step S50, and the color filter formed in step S52. Specifically, for example, a liquid crystal is poured into between the glass substrate and the color filter to form the liquid crystal panel. The module assembly step of step S56 is to attach various components such as electric circuits and backlights for display operation of this liquid crystal panel, to the liquid crystal panel assembled in step S54.

The present invention is not limited just to the application to the exposure apparatuss for manufacture of semiconductor devices, but can also be widely applied, for example, to the exposure apparatuss for the liquid crystal display devices formed with rectangular glass plates, or for display devices such as plasma displays, and to the exposure apparatuss for manufacture of various devices such as imaging devices (CCDs and others), micro machines, thin film magnetic heads, and DNA chips. Furthermore, the present invention is also applicable to the exposure step (exposure apparatus) for manufacture of masks (photomasks, reticles, etc.) on which mask patterns of various devices are formed, by the photolithography process.

The above-described embodiment can use the ArF excimer laser light (wavelength: 193 nm) or the KrF excimer laser light (wavelength: 248 nm) as the exposure light. Furthermore, without having to be limited to this, the present invention can also use any other appropriate laser light source, e.g., an F₂ laser light source which supplies laser light at the wavelength of 157 nm.

In the foregoing embodiment, it is also possible to apply a technique of filling the interior of the optical path between the projection optical system and the photosensitive substrate with a medium having the refractive index larger than 1.1 (typically, a liquid), which is so called a liquid immersion method. In this case, it is possible to adopt one of the following techniques as a technique of filling the interior of the optical path between the projection optical system and the photosensitive substrate with the liquid: the technique of locally filling the optical path with the liquid as disclosed in International Publication WO99/49504; the technique of moving a stage holding the substrate to be exposed, in a liquid bath as disclosed in Japanese Patent Application Laid-open No. 6-124873; the technique of forming a liquid bath of a predetermined depth on a stage and holding the substrate therein as disclosed in Japanese Patent Application Laid-open No. 10-303114, and so on. The teachings of International Publication WO99/49504, Japanese Patent Application Laid-open No. 6-124873, and Japanese Patent Application Laid-open No. 10-303114 are incorporated herein by reference.

In the above embodiment, it is also possible to apply the so-called polarization illumination methods as disclosed in U.S. Pat. Published Application Nos. 2006/0170901 and 2007/0146676. The teachings of U.S. Pat. Published Application Nos. 2006/0170901 and 2007/0146676 are incorporated herein by reference.

The foregoing embodiment was the application of the present invention to the illumination optical system for illuminating the mask in the exposure apparatus, but, without having to be limited to this, the present invention can also be applied to commonly-used illumination optical systems for illuminating an illumination target surface except for the mask.

## Claims

1. A spatial light modulating unit comprising:
a spatial light modulator having a plurality of optical elements arrayed two-dimensionally and controlled individually; and
an exit-side optical system which guides light having traveled via the plurality of optical elements of the spatial light modulator,
wherein the exit-side optical system is configured so that zero-order light having traveled via a surface portion other than the plurality of optical elements and approximately parallel to an array plane where the plurality of optical elements are arrayed, does not pass through an entrance pupil of the exit-side optical system.

2. The spatial light modulating unit according to claim 1, comprising an entrance-side optical system which guides light to the plurality of optical elements of the spatial light modulator.

3. The spatial light modulating unit according to claim 2, wherein optical surfaces of the plurality of optical elements in a standard state in which a parallel beam incident along an optical axis of the entrance-side optical system to the plurality of optical elements is guided via the plurality of optical elements and along an optical axis of the exit-side optical system, are inclined around a predetermined axis relative to the array plane.

4. The spatial light modulating unit according to claim 3, wherein the optical surfaces of the plurality of optical elements have a contour in which a length in a direction perpendicular to the predetermined axis is larger than a length in a direction parallel to the predetermined axis.

5. The spatial light modulating unit according to any one of claims 2 to 4, wherein the entrance-side optical system has a first deflecting member arranged on the spatial light modulator side, and wherein the exit-side optical system has a second deflecting member arranged on the spatial light modulator side.

6. The spatial light modulating unit according to claim 5, wherein an optical axis of the entrance-side optical system extending from the first deflecting member to the front side and an optical axis of the exit-side optical system extending from the second deflecting member to the rear side are coincident or parallel with each other,

7. The spatial light modulating unit according to claim 5 or 6, wherein the second deflecting member comprises a reflecting surface, and
wherein the zero-order light having traveled via the surface portion other than the plurality of optical elements and approximately parallel to the array plane where the plurality of optical elements are arrayed, travels to the outside of the reflecting surface of the second deflecting member.

8. The spatial light modulating unit according to any one of claims 2 to 7, wherein the entrance-side optical system is configured so that the zero-order light having traveled via the surface portion other than the plurality of optical elements and approximately parallel to the array plane where the plurality of optical elements are arrayed, does not pass through the entrance-side optical system.

9. The spatial light modulating unit according to any one of claims 1 to 8, wherein the spatial light modulator has a plurality of mirror elements arrayed two-dimensionally, and a drive unit which individually controls and drives postures of the plurality of mirror elements.

10. The spatial light modulating unit according to claims 9, wherein the drive unit continuously or discretely varies orientations of the plurality of mirror elements.

11. The spatial light modulating unit according to any one of claims 1 to 10, which is used together with an illumination optical system which illuminates an illumination target surface on the basis of light from a light source, the spatial light modulating unit guiding the light from the light source to a distribution forming optical system in the illumination optical system to form a predetermined light intensity distribution on an illumination pupil conjugate with the entrance pupil.

12. The spatial light modulating unit according to claim 11, wherein the illumination optical system is used in combination with a projection optical system which forms a plane optically conjugate with the illumination target surface, and wherein the illumination pupil is a position optically conjugate with an aperture stop of the projection optical system.

13. The spatial light modulating unit according to any one of claims 1 to 12, wherein the surface portion other than the plurality of optical elements and approximately parallel to the array plane where the plurality of optical elements are arrayed, is located between the plurality of optical elements.

14. An illumination optical system which illuminates an illumination target surface on the basis of light from a light source, said illumination optical system comprising:
the spatial light modulating unit as set forth in any one of claims 1 to 13; and
a distribution forming optical system which forms a predetermined light intensity distribution on an illumination pupil conjugate with the entrance pupil, based on a flux of light having traveled via the spatial light modulator.

15. The illumination optical system according to claim 14, wherein the distribution forming optical system has an optical integrator, and a condensing optical system arranged in an optical path between the optical integrator and the spatial light modulating unit.

16. The illumination optical system according to claim 14 or 15, which is used in combination with a projection optical system which forms a plane optically conjugate with the illumination target surface, wherein the illumination pupil is a position optically conjugate with an aperture stop of the projection optical system.

17. An exposure apparatus comprising the illumination optical system as set forth in any one of claims 14 to 16 for illuminating a predetermined pattern, wherein the predetermined pattern is transferred onto a photosensitive substrate to effect exposure thereof.

18. A device manufacturing method comprising:
an exposure step of transferring the predetermined pattern onto the photosensitive substrate to effect exposure thereof, using the exposure apparatus as set forth in claim 17;
a development step of developing the photosensitive substrate on which the predetermined pattern is transferred, to form a mask layer of a shape corresponding to the predetermined pattern on a surface of the photosensitive substrate; and
a processing step of processing the surface of the photosensitive substrate through the mask layer.

19. A spatial light modulator which modulates light incident thereto from a first optical system and guides the light to a second optical system,
the spatial light modulator comprising a plurality of optical elements arrayed two-dimensionally and controlled individually,
wherein optical surfaces of the plurality of optical elements in a standard state in which a parallel beam incident along an optical axis of the first optical system to the plurality of optical elements is guided via the plurality of optical elements and along an optical axis of the second optical system, are inclined around a predetermined axis relative to an array plane where the plurality of optical elements are arrayed.

20. The spatial light modulator according to claim 19, comprising a plurality of mirror elements arrayed two-dimensionally, and a drive unit which individually controls and drives postures of the plurality of mirror elements.

21. The spatial light modulator according to claim 20, wherein the drive unit continuously or discretely varies orientations of the plurality of mirror elements.

22. The spatial light modulator according to any one of clams 19 to 21, which is used together with an illumination optical system which illuminates an illumination target surface on the basis of light from a light source, the spatial light modulator guiding the light from the light source to a distribution forming optical system in the illumination optical system to form a predetermined light intensity distribution on an illumination pupil of the illumination optical system.

23. The spatial light modulator according to claim 22, wherein the illumination optical system is used in combination with a projection optical system which forms a plane optically conjugate with the illumination target surface, and wherein the illumination pupil is a position optically conjugate with an aperture stop of the projection optical system.

24. An illumination optical system which illuminates an illumination target surface on the basis of light from a light source, said illumination optical system comprising::
the spatial light modulator as set forth in any one of claims 19 to 23; and
a distribution forming optical system which forms a predetermined light intensity distribution on an illumination pupil of the illumination optical system, based on a flux of light having traveled via the spatial light modulator.

25. The illumination optical system according to claim 24, wherein the distribution forming optical system has an optical integrator, and a condensing optical system arranged in an optical path between the optical integrator and the spatial light modulator.

26. The illumination optical system according to claim 24 or 25, which is used in combination with a projection optical system which forms a plane optically conjugate with the illumination target surface, wherein the illumination pupil is a position optically conjugate with an aperture stop of the projection optical system.

27. An exposure apparatus comprising the illumination optical system as set forth in any one of claims 24 to 26 for illuminating a predetermine pattern, wherein the predetermined pattern is transferred onto a photosensitive substrate to effect exposure thereof.

28. A device manufacturing method comprising:
an exposure step of transferring the predetermined pattern onto the photosensitive substrate to effect exposure thereof, using the exposure apparatus as set forth in claim 27;
a development step of developing the photosensitive substrate on which the predetermined pattern is transferred, to form a mask layer of a shape corresponding to the predetermined pattern on a surface of the photosensitive substrate; and
a processing step of processing the surface of the photosensitive substrate through the mask layer.
